# EUROPÄISCHE PATENTSCHRIFT

(11) **EP 0 494 428 B1**
(45) Veröffentlichungstag und Bekanntmachung des Hinweises auf die Patenterteilung: **03.04.1996**
(21) Anmeldenummer: 91121910.3
(22) Anmeldetag: 20.12.1991
(51) Int. Cl.: G01R 11/04, G01R 22/00

(54) **Statischer Elektrizitätszähler**
Static electricity meter
Compteur électrique statique

(30) Priorität: 09.01.1991 CH 36/91
(43) Veröffentlichungstag der Anmeldung: 15.07.1992
(73) Patentinhaber: ZELLWEGER LUWA AG, CH-8610 Uster (CH)
(72) Erfinder: Warmerdam, Petrus, CH-8620 Wetzikon (CH)

(56) Entgegenhaltungen:
- AT-B- 389 173

## Beschreibung

Die vorliegende Erfindung betrifft einen statischen Elektrizitätszähler, mit einem zwei Anschlussklemmen für eine Phase des Verbraucherstroms sowie einen mit diesen verbundenen Stromsensor aufweisenden Messkreis.

An den heute bekannten Elektrizitätszählern, auch wenn diese sogenannte statische, das heisst elektronische, Zähler sind, scheint die zunehmende Miniaturisierung der Elektronik spurlos vorbeigegangen zu sein. Denn zumindest die Breite der Zählergehäuse, die im wesentlichen durch die nebeneinander angeordneten Anschlussklemmen bestimmt ist, wird kaum kleiner. Auch die Herstellkosten werden kaum günstiger, und es sind auch keine Synergieeffekte zwischen Ein- und Mehrphasenzählern festzustellen.

Durch die Erfindung soll nun einerseits eine Vereinfachung und Verbilligung der Zählerproduktion und anderseits eine spürbare Verkleinerung der Zählerdimensionen erreicht werden.

Diese Aufgabe wird dadurch gelöst, dass der Messkreis in Form eines flachen Modulbausteins ausgebildet ist, und dass die beiden Anschlussklemmen an einer der Stirnseiten des Bausteins übereinander angeordnet sind.

Die erfindungsgemässe Lösung führt bei gleichem Klemmenquerschnitt zu einer Halbierung der Zählerbreite und ermöglicht andererseits den Einsatz eines der Stromstärke angepassten Klemmenquerschnitts. Die Ausbildung als Modulbaustein führt zu einer Reduktion der Herstellkosten, weil praktisch nur Einphasen-Modulbausteine hergestellt werden müssen, dies dafür in dreifacher Stückzahl. Wenn auch die Nulleitermodule in gleicher Form wie die die Messkreise bildenden Modulbausteine ausgebildet werden, ergibt sich ein einheitliches Aussehen der verschiedenen Module und ein durchgehender modularer Aufbau der Elektrizitätszähler.

Nachstehend wird die Erfindung anhand eines Ausführungsbeispiels und der Zeichnungen näher erläutert; es zeigt:
- Fig. 1: eine Vorderansicht einer Messzelle eines Elektrizitätszählers,
- Fig. 2: eine Ansicht in Richtung des Pfeiles II von Fig. 1,
- Fig. 3: eine Draufsicht auf die Messzelle von Fig. 1,
- Fig. 4: eine schematische Darstellung eines Zählergehäuses und der in diesem angeordneten Module; und
- Fig. 5: eine Explosionsdarstellung eines Zählergehäuses mit Modulen zur Veranschaulichung des modularen Gerätekonzepts.

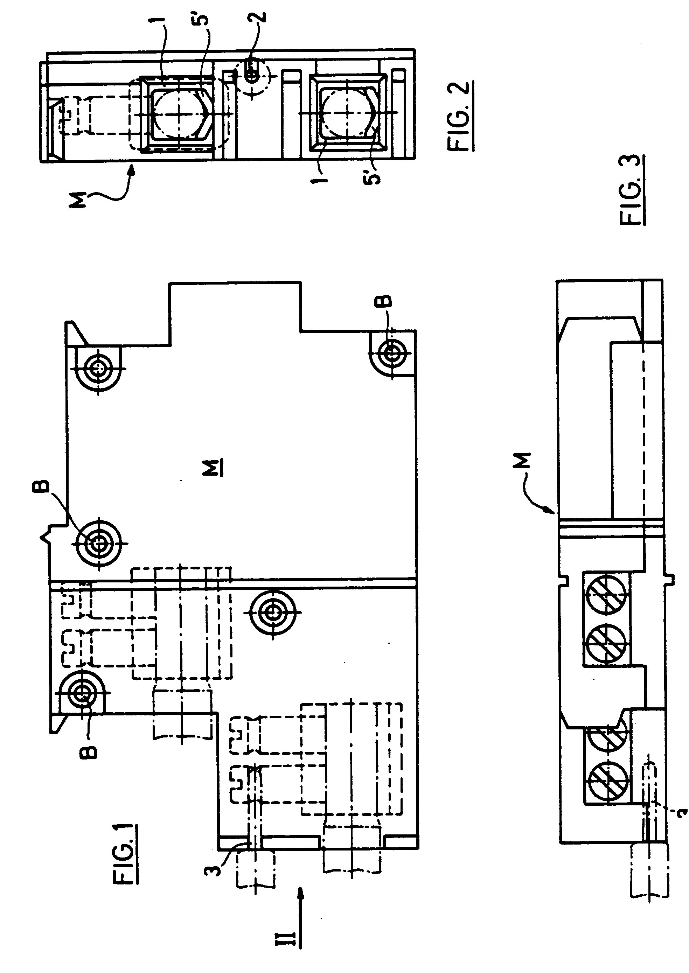

Die Figuren 1 bis 3 zeigen eine Messzelle M eines Elektrizitätszählers in drei Ansichten im Massstab von 1,5 : 1. Diese Messzelle hat darstellungsgemäss die Form einer flachen Schachtel mit den ungefähren Abmessungen 90x60x16 Millimeter und sie enthält einen Messkreis für eine Phase des zu messenden Stroms. Ist dieser Strom ein dreiphasiger Wechselstrom, dann enthält der betreffende Elektrizitätszähler drei derartige Messzellen M und ein Nulleitermodul von gleicher Form, wodurch ein durchgehend modularer Aufbau und ein einheitliches Aussehen der Elektrizitätszähler erreicht wird. An der Aussenwand der Messzelle M vorgesehene Rippen und Nuten dienen zur Zentrierung der einzelnen Module im Zählergehäuse und untereinander; mit dem Bezugszeichen B sind Nieten zur Befestigung des Gehäusedeckels bezeichnet.

Jede Messzelle M enthält insbesondere zwei Anschlussklemmen 1 eines Strompfades, welche darstellungsgemäss nicht, wie bisher üblich, neben-, sondern übereinander angeordnet sind, wodurch sich für einen Dreiphasenzähler eine beachtliche Reduktion der Gehäusebreite ergibt. Selbstverständlich müssen die beiden Anschlussklemmen 1 nicht unbedingt miteinander fluchten; sie können gegeneinander auch leicht versetzt sein. Wesentlich ist, dass sie über- und nicht nebeneinander liegen. Der gegenseitige Abstand kann dabei minimal sein, da ja die beiden Anschlussklemmen des Strompfades einer Phase die gleiche Spannung aufweisen und somit nicht die für die Erzielung der zwischen zwei Phasen vorgeschriebenen Stossspannungsfestigkeit erforderliche Mindestdistanz nötig ist. Der Querschnitt der Anschlussklemmen kann bei der Anordnung übereinander wesentlich grösser gewählt werden als bisher und er kann damit in weiten Grenzen der jeweiligen Stromstärke angepasst werden.

Wie insbesondere aus Fig. 2 ersichtlich ist, weist die Messzelle M neben den Anschlussklemmen 1 noch eine Anschlussbuchse 2 für einen bananensteckerartigen Stift oder Bolzen 3 auf, der zur Eichung des Zählers dient, und dessen Funktion in der CH-Patentanmeldung Nr. 00 037/91-4 vom 09.01.1991 beschrieben ist.

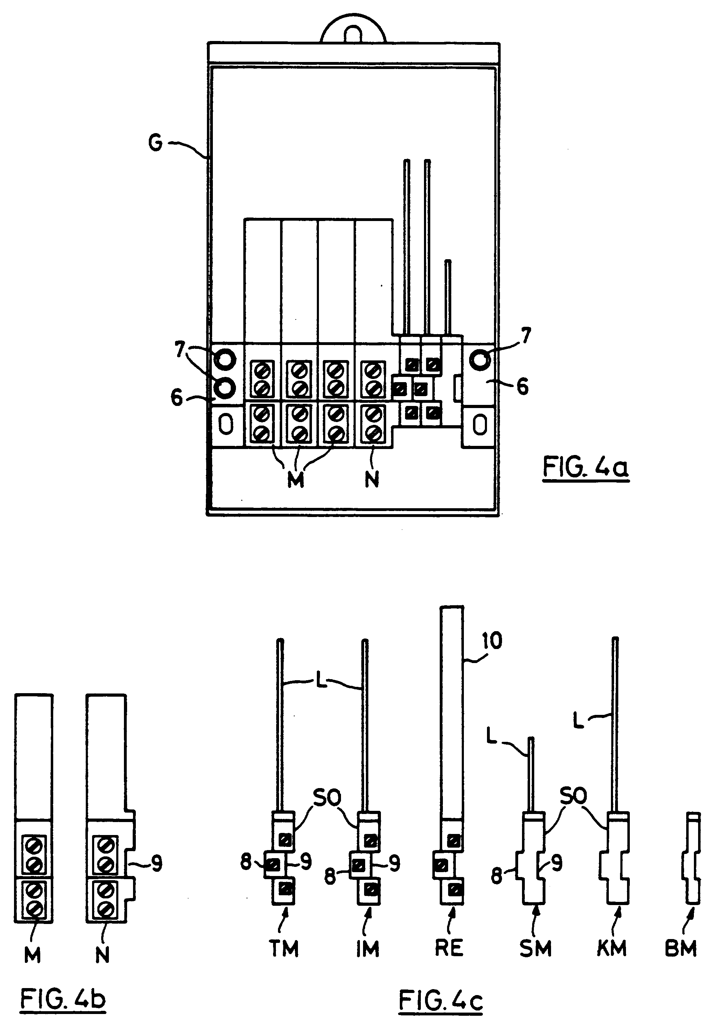

Fig 4a zeigt eine schematische Darstellung des Unterteils G eines Zählergehäuses und der im Gehäuse angeordneten Module, welche in den Fig. 4b und 4c einzeln dargestellt sind. Der Gehäuseunterteil G enthält darstellungsgemäss zwei Montageschienen 6 mit Nuten und Rippen zum Eingriff der entsprechenden Gegenstücke der einzelnen Module. Auf diese Weise kann die Montage der Module im Gehäuse durch einfaches Hineinstecken des Modulpakets in die Montageschienen 6 erfolgen. Die Fixierung des Modulpakets erfolgt durch Verschrauben des Deckels (nicht dargestellt) mit Bohrungen 7 in den Montageschienen 6.

Der Zähler gemäss Fig. 4a enthält drei Messmodule (Messzellen) M der in den Fig. 1 bis 3 dargestellten Art und ein Nullmodul N; dieses sind die sogenannten Basismodule, die in Fig. 4b nochmals gesondert dargestellt sind. Der im Anschluss an das Nullmodul N verbleibende Platz ist für sogenannte Optionsmodule für Zusatzfunktionen (Fig. 4b) vorgesehen. Alle diese Optionsmodule weisen an ihrer einen Seitenfläche eine Fixierrippe 8 und an ihrer anderen Seitenfläche eine Fixiernut 9 auf; das Nullmodul N ist an seiner an die Optionsmodule angrenzenden Seitenfläche ebenfalls mit einer Fixiernut 9 versehen, so dass alle diese Module einfach ineinander geschoben und fixiert werden können.

Folgende Optionsmodule können vorhanden sein:
- Von einem Rundsteuerempfänger angesteuerte Schaltrelais RE;
- Tarifmodule TM für externe Tarif- oder Periodensteuerung;
- Impulsweitergabekontakte IM für die Weitergabe der Messimpulse für andere Zwecke, beispielsweise für Anzeigen oder dergleichen, und/oder von Steuerimpulsen für einen Maximumzähler. Diese Steuerimpulse können beispielsweise solche für die Messperiode oder für die Rückstellung des Maximumzählers sein.
- Schnittstellen SM für Fernablesung des Zählers, sei dies eine gezielte, aktive Fernablesung an einem vom Zähler entfernten Ort, beispielsweise durch Einschieben einer Karte in ein Ausgabegerät, oder durch Rückmeldung des Zählerstandes über das Netz an eine Zentrale.
- Kundenspezifische Module KM zum Anschluss externer Zählimpulse von anderen Zählern (z.B. Gas, Wasser);
- Blindteile BM zum Ausfüllen eines eventuell freien Raums zwischen den Montageschienen.

Alle Optionsmodule weisen einen Sockelteil SO auf, an welchem die Fixierrippe 8 und die Fixiernut 9 sowie die erforderlichen Kontakte ausgebildet sind. Die Blindteile BM bestehen nur aus einem Sockel, bei den Schaltrelais RE ist an den Sockel ein flaches Gehäuse 10 angearbeitet, in welchem das eigentliche Relais angeordnet ist. Bei den übrigen Optionsmodulen, das ist bei den Tarifmodulen TM, bei den Impulsweitergabekontakten IM, bei den Schnittstellen SM für Zählerfernablesung und bei den kundenspezifischen Modulen KM trägt der Sockel SO eine Leiterplatte L. Ausserdem sind sämtliche Module, also die Basis- und die Optionsmodule in der Breite aufeinander abgestimmt. Beispielsweise haben alle Basismodule M und N eine Breite von 16,5 und alle Optionsmodule (mit Ausnahme der Blindteile BM) eine Breite von 11 Millimetern. Die Breite der Blindteile BM beträgt 5 mm und der Abstand zwischen den Montageschienen 6 beträgt ein ganzzahliges Vielfaches der Basismodulbreite. Es ist leicht einzusehen, dass mit dieser Breitenabstufung der Raum zwischen den Montageschienen immer vollständig ausgefüllt werden kann.

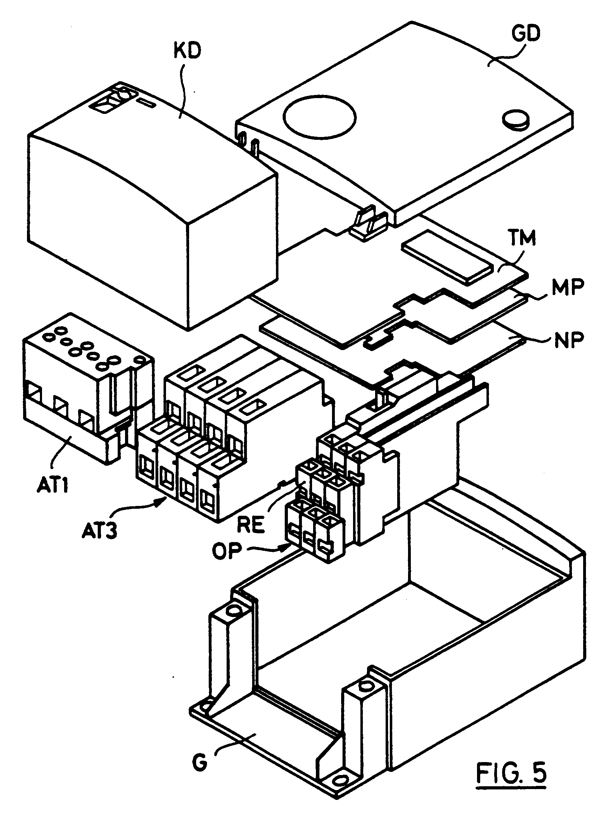

Fig. 5 zeigt das modulare Gerätekonzept anhand einer Explosionsdarstellung der einzelnen Teile eines Elektrizitätszählers. Mit dem Bezugszeichen G ist so wie in Fig. 4a der Gehäuseunterteil bezeichnet; mit AT3 ein dreiphasiger Anschlussteil mit integriertem Messwandler, welcher analog zu Fig. 4a drei Messmodule M und ein Nullmodul N enthält; mit dem Bezugszeichen AT1 ein einphasiger Anschlussteil mit zwei Messkreisen, der alternativ zum dreiphasigen Anschlussteil AT3 in den Gehäuseunterteil G einsetzbar ist; und mit dem Bezugszeichen OP drei Optionsmodule, darunter ganz links ein Schaltrelais RE.

Wenn die benötigten Anschlussteile und Optionsmodule im Gehäuseunterteil G befestigt sind, werden noch einige plattenartige Module aufgesetzt, und zwar eine Messplatine MP mit einer Schnittstelle zu den Optionsmodulen, ein Tarifmodul TM mit einem geeigneten Anzeigefeld (LCD) und einer optoelektronischen Schnittstelle, und eine Netzteilplatine NP, letztere allerding nur bei dreiphasigen Zählern. Schliesslich werden der Gehäusedeckel GD und der Klemmendeckel KD befestigt, welche beide plombierbar sind.

Die beschriebene Ausbildung des Messkreises als Modulbaustein mit übereinander angeordneten Anschlussklemmen verkleinert die Zählerdimensionen ganz erheblich und führt zu einer merkbaren Reduktion der Herstellungskosten, indem für die Messkreise nur noch ein Modell eines Modulbausteins hergestellt werden muss, dieses noch dazu in entsprechend höherer Stückzahl.

Das beschriebene Konzept erlaubt es, dass die endgültige, an den Kunden auszuliefernde Konfiguration erst sehr spät im Produktionsablauf festgelegt zu werden braucht, und dass auch bereits ausgelieferte und montierte Zähler durch Einfügen oder Ersetzen von Modulen erweitert oder modifiziert werden können. Letzteres ist nicht nur ein Vorteil für den Hersteller, sondern auch für den Kunden.

## Patentansprüche

1. Statischer Elektrizitätszähler, mit einem zwei Anschlussklemmen für eine Phase des Verbraucherstroms sowie einen mit diesen verbundenen Stromsensor aufweisenden Messkreis, dadurch gekennzeichnet, dass der Messkreis in Form eines flachen Modulbausteins (M) ausgebildet ist, und dass die beiden Anschlussklemmen (1) an einer der Stirnseite des Bausteins übereinander angeordnet sind.

2. Elektrizitätszähler nach Anspruch 1, dadurch gekennzeichnet, dass die beiden Anschlussklemmen (1) vertikal übereinanderliegen und in der Tiefe gegeneinander versetzt sind.

3. Elektrizitätszähler nach Anspruch 2, dadurch gekennzeichnet, dass der Modulbaustein (M) eine schachtelartige Form aufweist und an seinen Aussenflächen mit Rippen und Nuten versehen ist, welche zum Eingriff mit entsprechenden Nuten beziehungsweise Rippen anderer Modulbausteine oder eines Zählergehäuses vorgesehen sind.

4. Elektrizitätszähler nach Anspruch 3, gekennzeichnet durch ein in Art der Messzelle oder Messzellen (M) ebenfalls als Modulbaustein ausgebildetes Nullmodul (N).

5. Elektrizitätszähler nach Anspruch 4, dadurch gekennzeichnet, dass zusätzlich zu den genannten und nachfolgend als Basismodule bezeichneten Modulbausteinen (M,N) noch sogenannte Optionsmodule (OP) für Zusatzfunktionen vorgesehen sind.

6. Elektrizitätszähler nach Anspruch 5, dadurch gekennzeichnet, dass die Optionsmodule(OP) ähnlich wie die Basismodule (M,N) ausgebildet sind, und an ihrer einen Seitenfläche eine Fixierrippe (8) und an ihrer anderen Seitenfläche eine Fixiernut (9) aufweisen.

7. Elektrizitätszähler nach Anspruch 6, dadurch gekennzeichnet, dass die Basismodule (M,N) und die Optionsmodule (OP) zu einem Modulpaket zusammensteckbar, und dass im Zählergehäuse (G) Haltemittel (6) zur Aufnahme des Modulpakets vorgesehen sind.

8. Elektrizitätszähler nach Anspruch 7, dadurch gekennzeichnet, dass die Haltemittel (6) durch Montageschienen gebildet sind, in welche das Modulpaket hineinschiebbar ist.

9. Elektrizitätszähler nach Anspruch 6, dadurch gekennzeichnet, dass die Optionsmodule aus einem Sockelteil (SO) und aus einer von diesem getragenen Leiterplatte (L) bestehen.

10. Elektrizitätszähler nach einem der Ansprüche 7 bis 9, gekennzeichnet durch ähnlich wie die Optionsmodule (OP) ausgebildete Blindteile (BM) zur Apassung der Breite des Modulpakets an den Abstand zwischen den Haltemitteln.

11. Elektrizitätszähler nach Anspruch 6, gekennzeichnet durch ein ein Optionsmodul (OP) bildendes, von einem Rundsteuerempfänger angesteuertes Schaltrelais (RE).

12. Elektrizitätszähler nach Anspruch 6,gekennzeichnet durch ein ein Optionsmodul (OP) bildendes sogenanntes Tarifmodul (TM) für externe Tarif- oder Periodensteuerung.

13. Elektrizitätszähler nach Anspruch 6, gekennzeichnet durch ein Optionsmodul (OP) bildende Impulsweitergabekontakte (IM) für die Weitergabe der Messimpulse und/oder von Steuerimpulsen.

14. Elektrizitätszähler nach Anspruch 6, gekennzeichnet durch eine ein Optionsmodul (OP) bildende Schnittstelle (SM) für die Fernablesung des Zählers.

15. Elektrizitätszähler nach Anspruch 6, gekennzeichnet durch ein ein Optionsmodul (OP) bildendes kundenspezifisches Modul (KM) zum Anschluss externer Zählimpulse.

## Claims

1. Electronic electricity meter with a measuring circuit having two connecting terminals for one phase of the load current and a current sensor connected thereto, characterised in that the measuring circuit is designed in the form of a flat module (M), and in that the two connecting terminals (1) are arranged one above the other on one of the end faces of the module.

2. Electricity meter according to Claim 1, characterised in that the two connecting terminals (1) are located vertically one above the other and are offset in depth with respect to one another.

3. Electricity meter according to Claim 2, characterised in that the module (M) has a box-like shape and is provided on its outer surfaces with ribs and slots, which are provided for engagement with corresponding slots and ribs of other modules or of a meter housing.

4. Electricity meter according to Claim 3, characterised by a neutral module (N) designed in the manner of a measuring cell or measuring cells (M), likewise as a module.

5. Electricity meter according to Claim 4, characterised in that, in addition to the said modules (M,N), referred to in the following text as base modules, so-called option modules (OP) are also provided for additional functions.

6. Electricity meter according to Claim 5, characterised in that the option modules (OP) are designed similarly to the base modules (M,N) and have a fixing rib (8) on their one end surface and a fixing slot (9) on their other end surface.

7. Electricity meter according to Claim 6, characterised in that the base modules (M,N) and the option modules (OP) can be plugged together to form a module stack and in that means of retention (6) are provided in the meter housing (G) for holding the module stack.

8. Electricity meter according to Claim 7, characterised in that the means of retention (6) are formed by mounting rails, into which the module stack can be pushed.

9. Electricity meter according to Claim 6, characterised in that the option modules consist of a base part (SO) and of a printed-circuit board (L) supported thereby.

10. Electricity meter according to one of Claims 7 to 9, characterised by blanking parts (BM), of similar design to the option modules (OP), for matching the width of the module stack to the distance between the means of retention.

11. Electricity meter according to Claim 6, characterised by a switching relay (RE), forming an option module (OP) and triggered by a ripple-control receiver.

12. Electricity meter according to Claim 6, characterised by a so-called tariff module (TM), forming an option module (OP), for external tariff or period control.

13. Electricity meter according to Claim 6, characterised by pulse transferring contacts (IM), forming an option module (OP), for transferring measuring pulses and/or control pulses.

14. Electricity meter according to Claim 6, characterised by an interface (SM), forming an option module (OP), for remote reading of the meter.

15. Electricity meter according to Claim 6, characterised by a customer-specific module (KM), forming an option module (OP), for the connection of external meter pulses.

## Revendications

1. Compteur électrique statique comprenant un circuit de mesure ayant deux organes de contact pour une phase du courant de charge et un capteur de courant, caractérisé en ce que le circuit de mesure est formé par un élément modulaire (M) plat et en ce que les deux organes de contact (1) sont disposés l'un sur l'autre dans une face frontale de l'élément modulaire.

2. Compteur électrique statique selon la revendication 1, caractérisé en ce que les deux organes de contact (1) sont placés l'un sur l'autre en sens vertical et sont décalés en profondeur.

3. Compteur électrique statique selon la revendication 2, caractérisé en ce que l'élément modulaire a la forme d'une boîte dont les faces extérieures sont pourvues de rainures et cannelures pouvant s'engrener dans des cannelures et rainures d'autres éléments modulaires ou d'un boîtier de compteur.

4. Compteur électrique statique selon la revendication 3, caractérisé par un module neutre (N) ressemblant à une ou plusieurs cellules de mesure tel qu'un élément modulaire.

5. Compteur électrique statique selon la revendication 4, caractérisé en ce qu'en plus des éléments modulaires (M, N) précités, qui par la suite seront désignés comme modules de base, des modules d'option (OP) sont prévus pour des fonctions supplémentaires.

6. Compteur électrique statique selon la revendication 5, caractérisé en ce que les modules d'option sont similaires aux modules de base (M, N) et sont pourvus d'une rainure de fixation sur l'une des faces latérales et d'une cannelure de fixation sur la face latérale opposée.

7. Compteur électrique statique selon la revendication 6, caractérisé en ce que les modules de base (M, N) et les modules d'option (OP) peuvent être assemblés pour former un assemblage et en ce que des supports (6) sont prévus dans le boîtier (G) du compteur pour l'assemblage de modules.

8. Compteur électrique statique selon la revendication 1, caractérisé en ce que les supports (6) sont constitués par des rails de montage, entre lesquels l'assemblage de modules peut être introduit.

9. Compteur électrique statique selon la revendication 6, caractérisé en ce que les modules d'option se composent d'un socle (SO) et d'une carte de circuits imprimés (L) supportée par celui-là.

10. Compteur électrique statique selon l'une des revendications 7 à 9, caractérisé par des faux-modules (BM) d'aspect semblable aux modules d'option (OP) et destinés à adapter la largeur des assemblages de modules à l'écartement des supports.

11. Compteur électrique statique selon la revendication 6, caractérisé par un relais (RE) formant un module d'option (OP) et commandé par un récepteur de commande circulaire.

12. Compteur électrique statique selon la revendication 6, caractérisé par un module de tarif (TM) pour la commande externe de tarifs ou de périodes constituant un module d'option (OP).

13. Compteur électrique statique selon la revendication 6, caractérisé par des contacts de transmission d'impulsions (IM) pour le transfer d'impulsions de mesure et de commande constituant un module d'option (OP).

14. Compteur électrique statique selon la revendication 6, caractérisé par un interface (SM) de lecture de compteur à distance constituant un module d'option (OP).

15. Compteur électrique statique selon la revendication 6, caractérisé par un module (KM) spécific à un client pour le raccord d'impulsions externes constituant un module d'option (OP).
